# EUROPÄISCHE PATENTSCHRIFT

(11) **EP 3 314 617 B1**
(45) Veröffentlichungstag und Bekanntmachung des Hinweises auf die Patenterteilung: **03.01.2024**
(21) Anmeldenummer: 16728933.9
(22) Anmeldetag: 10.06.2016
(51) Int. Cl.: H01F 3/14, H01F 17/04, H01F 17/06

(54) **INDUKTIVES BAUTEIL FÜR EINE STROMSCHIENE**
INDUCTIVE COMPONENT FOR A BUS BAR
COMPOSANT INDUCTIF POUR UNE BARRE OMNIBUS

(30) Priorität: 24.06.2015 DE 102015110142
(43) Veröffentlichungstag der Anmeldung: 02.05.2018
(73) Patentinhaber: TDK Electronics AG, 81671 München (DE)
(72) Erfinder: SCHLIEWE, Jörn, 89555 Steinheim (DE); SCHEFLER, Stefan, 89081 Ulm (DE)
(74) Vertreter: Epping - Hermann - Fischer
(86) Internationale Anmeldenummer: PCT/EP2016/063303
(87) Internationale Veröffentlichungsnummer: WO 2016/206993

(56) Entgegenhaltungen:
- EP-A1- 0 133 695
- EP-A1- 2 669 911
- EP-A1- 2 800 218
- WO-A1-2009/123433
- WO-A1-2012/120367
- DE-A1-102012 104 348
- GB-A- 2 442 090
- JP-A- 2009 071 248
- US-A1- 2006 043 960
- US-A1- 2010 013 587
- US-A1- 2010 033 284
- US-A1- 2010 171 580

## Beschreibung

Es wird eine Anordnung aufweisend ein induktives Bauteil und eine Stromschiene angegeben. Das induktive Bauteil wird insbesondere zur Filterung von Störungen, insbesondere von hochfrequenten Störungen, in der Stromschiene eingesetzt.

Die Druckschrift EP 2 800 218 A1 beschreibt eine Stromschienenvorrichtung mit Magnetkern.

Die Druckschrift EP 2 669 911 A1 betrifft eine Induktivität aufweisend zwei Spulen, die um einen Magnetkern gewickelt sind. Der Magnetkern weist auf seinen gegenüberliegenden Seiten Luftspalte auf unterschiedlicher Höhe auf, wobei die Spulen jeweils einen der Luftspalte umgeben.

Die Druckschriften EP 0 133 695 A1, DE 10 2012 104348 A1, US 2006/043960 A1 beschreiben Anordnungen aus stromführenden Leitern, die durch Magnetkerne geführt sind.

Die Druckschrift US 2010/0171580 A1 beschreibt einen Magnetkern für eine Drossel.

Es ist eine Aufgabe der vorliegenden Erfindung, eine verbesserte Anordnung aufweisend ein induktive Bauteil und eine Stromschiene anzugeben.

Die Erfindung betrifft eine Anordnung aufweisend ein induktives Bauteil und eine Stromschiene mit den Merkmalen des Patentanspruchs 1.

Die Stromschiene ist durch das induktive Bauteil geführt. Vorzugsweise handelt es sich um eine Kupfer-Stromschiene. Die Stromschiene ist beispielsweise zur Leitung des Stromes bei einem Umrichter ausgebildet. Das induktive Bauteil dient beispielsweise zur Filterung hochfrequenter Störungen bei einem niederfrequenten Nutzsignal.

Das induktive Bauteil weist zwei Luftspalte auf. Die Luftspalte sind an gegenüberliegenden Seiten des Bauteils angeordnet. Beispielsweise weist das Bauteil eine Öffnung zur Durchführung der Stromschiene auf. Die Luftspalte befinden sich vorzugsweise auf Seiten des Bauteils zwischen denen die Öffnung liegt. Bei einer durch das Bauteil hindurchgeführten Stromschiene sind die Luftspalte entsprechend an gegenüberliegenden Seiten der Stromschiene angeordnet.

Die Luftspalte weisen in einer Höhenrichtung des Bauteils einen Abstand voneinander auf. Als Höhenrichtung wird dabei eine Richtung senkrecht zum Verlauf der Stromschiene, d.h., senkrecht zur Flussrichtung des Stromes durch die Stromschiene bezeichnet. Vorzugsweise verläuft die Höhenrichtung parallel zu den gegenüberliegenden Seiten des Bauteils, an dem die Luftspalte angeordnet sind. Somit sind die Luftspalte auf unterschiedlichen Höhen des Bauteils angeordnet, insbesondere versetzt zueinander angeordnet. Vorzugsweise weisen die Luftspalte den gleichen Abstand zur halben Höhe des Bauteils auf. Beispielsweise sind der erste Luftspalt unterhalb der halben Höhe des Bauteils und der zweite Luftspalt oberhalb der halben Höhe des Bauteils angeordnet.

Durch die beabstandete Anordnung der Luftspalte können vorzugsweise die Verluste in der Stromschiene reduziert werden. Insbesondere kann eine homogenere Stromdichteverteilung in der Stromschiene erreicht werden. Dieser Effekt kann dabei vorzugsweise ohne Vergrößerung des Bauteils und ohne Erhöhung der Kosten erzielt werden.

Das induktive Bauteil weist zwei Bauteilkomponenten auf. Insbesondere handelt es sich dabei um zwei Kerne aus weichmagnetischem Material, zum Beispiel Ferrit. Die Luftspalte sind zwischen den Kernen angeordnet.

In einer Ausführungsform der Erfindung weisen die Kerne die gleiche Form auf.

Erfindungsgemäß weist jeder der Kerne einen ersten Schenkel und einen zweiten Schenkel auf, wobei der erste Schenkel eine andere Länge aufweist als der zweite Schenkel. Beispielsweise weist jeder Kern genau zwei Schenkel auf. Die Schenkel jedes Kerns sind vorzugsweise durch ein Verbindungsstück miteinander verbunden. In einer Ausführungsform der Erfindung weisen die Kerne jeweils die Form eines "U"-Kerns oder eines "C"-Kerns mit unterschiedlich langen Schenkeln auf.

Erfindungsgemäß sind der erste Luftspalt zwischen dem ersten Schenkel des ersten Kerns und dem zweiten Schenkel des zweiten Kerns und der zweite Luftspalt zwischen dem zweiten Schenkel des ersten Kerns und dem ersten Schenkel des zweiten Kerns angeordnet. Die Luftspalte sind vorzugsweise bezüglich einer Richtung, die sich vom Verbindungsstück zum freien Ende des Schenkels erstreckt, gegeneinander versetzt angeordnet.

Z P In einer Ausführungsform der Erfindung beträgt der Abstand der Luftspalte in Höhenrichtung mindestens 1/4 der Summe aus den Längen eines ersten Schenkels, eines zweiten Schenkels und der Höhe des Luftspalts. Vorzugsweise wird die Öffnung zur Durchführung der Stromschiene seitlich von einem ersten Schenkel, dem Luftspalt und dem zweiten Schenkel begrenzt. Die Höhe der Öffnung ist dann vorzugsweise gleich der Summe aus den Längen des ersten Schenkels, des zweiten Schenkels und der Höhe des Luftspalts. Somit beträgt der Abstand der Luftspalte in Höhenrichtung mindestens 1/4 der Höhe der Öffnung. Bei einem derartigen Abstand der Luftspalte können die Verluste in der Stromschiene um bis zu 50% reduziert werden.

In einer Ausführungsform der Erfindung beträgt der Abstand der Luftspalte in Höhenrichtung höchstens 3/4 der Summe der Längen eines ersten Schenkels eines zweiten Schenkels und der Höhe eines Luftspalts beträgt. Entsprechend beträgt der Abstand der Luftspalte in Höhenrichtung höchstens 3/4 der Höhe der Öffnung. Bei einer Positionierung der Luftspalte nah am Verbindungsstück können die Verluste in der Stromschiene wieder zunehmen. Somit ist es günstig, die Luftspalte nicht zu nah am Verbindungsstück vorzusehen. Vorzugsweise beträgt der Abstand der Luftspalte zum oberen Ende bzw. zum unteren Ende der Öffnung mindestens 1/8 der Höhe der Öffnung. In einer Ausführungsform sind die Luftspalte in einem Abstand von mindestens 10 mm, zum Beispiel in einem Abstand von 12,5 mm, zum oberen und unteren Ende der Öffnung angeordnet.

Beispielsweise liegt der Abstand der Luftspalte in Höhenrichtung in einem Bereich zwischen 1/4 der Höhe der Öffnung und 3/4 der Höhe der Öffnung. Insbesondere kann der Abstand bei ungefähr 1/2 der Höhe der Öffnung liegen.

In einer Ausführungsform der Erfindung ist das Bauteil punktsymmetrisch ausgebildet. Insbesondere ist das Bauteil symmetrisch bezüglich einer Drehung um 180° um eine Achse ausgebildet, wobei die Achse zentral durch die Öffnung und in Richtung des Stromflusses verläuft. Auf diese Weise kann dieselbe Kernform für beide Hälften verwendet werden.

Das induktive Bauteil der Anordnung weist beispielsweise einen wie folgt beschriebenen Kern auf. Der Kern weist zwei Schenkel auf, die unterschiedlich lang ausgebildet sind.

Insbesondere weist der Kern genau zwei Schenkel auf. In einer Ausführungsform der Erfindung ist der Kern als "U-Kern" oder "C-Kern" mit unterschiedlich langen Schenkeln ausgebildet. Der Kern eignet sich insbesondere für das vorgehend beschriebene Bauteil und kann alle diesbezüglich beschriebenen strukturellen und funktionellen Eigenschaften aufweisen.

Vorzugsweise weist das Bauteil zwei derartige Kerne auf. Die Kerne sind beispielsweise derart angeordnet, dass das Bauteil eine Öffnung für eine Stromschiene aufweist. Die Öffnung wird vorzugsweise seitlich jeweils durch einen ersten Schenkel eines der Kerne und einen zweiten Schenkel des anderen Kerns begrenzt. Nach oben und unten wird die Öffnung vorzugsweise durch jeweils ein Verbindungsstück eines Kerns begrenzt. Das induktive Bauteil kann alle strukturellen und funktionellen Eigenschaften des oben beschriebenen Bauteils aufweisen. Insbesondere kann das Bauteil zwei in ihrer Höhe gegeneinander versetzte Luftspalte aufweisen.

Das Bauteil der Anordnung weist zwei Luftspalte auf, die an gegenüberliegenden Seiten der Stromschiene angeordnet sind. Dabei handelt es sich um Längsseiten der Stromschiene. Beispielsweise weist die Stromschiene im Querschnitt, d.h., senkrecht zu einer Flussrichtung des Stroms, eine rechteckige Form auf. Die Stromschiene weist zwei Längsseiten und zwei Stirnseiten auf. Die Höhe der Längsseiten ist größer als die Breite der Stirnseiten.

In einer Ausführungsform der Erfindung wird das induktive Bauteil zur Verwendung in einem EMV-Filter ausgebildet, wobei EMV die "Elektromagnetische Verträglichkeit" bezeichnet. In einem Anwendungsbeispiel handelt es sich um einen Eingangsfilter für einen Umrichter.

In der vorliegenden Offenbarung sind mehrere Aspekte einer Erfindung beschrieben. Alle Eigenschaften, die in Bezug auf den das induktive Bauteil, den Kern und/oder die Anordnung beschrieben ist, ist auch entsprechend in Bezug auf die jeweiligen anderen Aspekte offenbart, auch wenn die jeweilige Eigenschaft nicht explizit im Kontext des jeweiligen Aspekts erwähnt wird.

Im Folgenden werden die hier beschriebenen Gegenstände anhand von schematischen und nicht maßstabsgetreuen Ausführungsbeispielen näher erläutert.

Es zeigen:

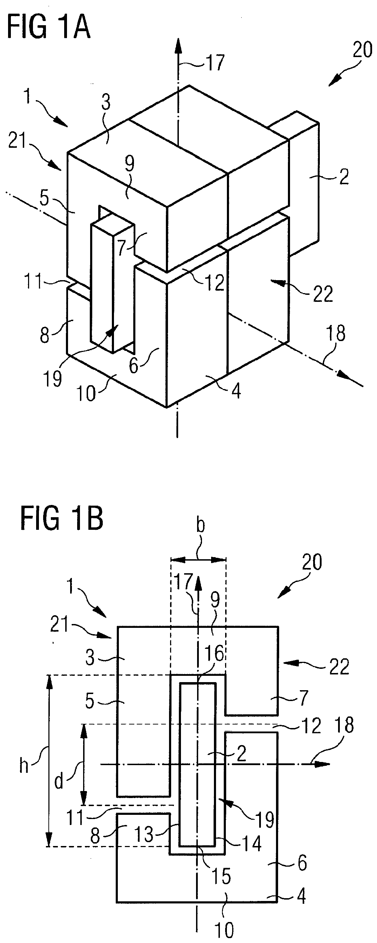

- Figur 1A: in perspektivischer Ansicht eine Ausführungsform einer Anordnung eines induktiven Bauteils und einer Stromschiene,
- Figur 1B: in einer Schnittansicht die Ausführungsform nach Figur 1A.

Vorzugsweise verweisen in den folgenden Figuren gleiche Bezugszeichen auf funktionell oder strukturell entsprechende Teile der verschiedenen Ausführungsformen.

Figur 1A zeigt in perspektiver Ansicht eine Anordnung 20 eines induktiven Bauteils 1 und einer Stromschiene 2. Figur 1B zeigt die Anordnung 20 im Querschnitt.

Die Stromschiene 2 besteht beispielsweise aus Kupfer. Die Stromschiene 2 eignet sich vorzugsweise zur Leitung von großen Strömen. Beispielsweise wird die Stromschiene 2 zur Leitung des Stromes bei einem Umrichter eingesetzt. Der Umrichter dient beispielsweise zur Stromversorgung elektrischer Maschinen, insbesondere von Motoren.

Das induktive Bauteil 1 wird beispielsweise bei einem EMV-Filter eingesetzt, d.h., bei einem Filter zur Erzielung Elektromagnetischer Verträglichkeit (EMV). Insbesondere handelt es sich um einen Stromschienenfilter. Beispielsweise weist ein derartiger Filter mehrere miteinander verschaltete Induktivitäten und Kondensatoren an mehreren Stromschienen auf. Vorzugsweise dient der Filter zur Filterung hochfrequenter Störungen bei einem niederfrequenten Nutzsignal. Beispielsweise weist das Nutzsignal eine Frequenz von ca. 50 Hz auf. Insbesondere eignet sich der Filter für Gegentaktstörungen (Differential Mode).

Das induktive Bauteil 1 weist zwei Bauteilkomponenten auf. Die Bauteilkomponenten sind als Kerne 3, 4, insbesondere als magnetische Kerne ausgebildet. Beispielsweise handelt es sich um Ferritkerne. Jeder Kern 3, 4 weist einen ersten Schenkel 5, 6 und einen zweiten Schenkel 7, 8 auf, die jeweils durch ein Verbindungsstück 9, 10 der Kerne 3, 4 miteinander verbunden sind. Die Kerne 3, 4 sind derart angeordnet, dass das induktive Bauteil 1 zwei Luftspalte 11, 12 aufweist. Beispielsweise ist jeder der Kerne 3, 4 einstückig ausgebildet, zum Beispiel als ein Teil gepresst. Die Kerne 3, 4 können jedoch auch aus einzelnen Kernen, beispielsweise I-förmigen Kernen zusammengesetzt sein.

Das induktive Bauteil 1 kann mehrere derartige Anordnungen von Kernen 3, 4 aufweisen. Vorliegend sind hinter den Kernen 3, 4 zwei weitere Kerne 23, 24 angeordnet, die wie die Kerne 3, 4 ausgebildet sind.

Insbesondere ist zwischen dem ersten Schenkel 5 des ersten Kerns 3 und dem zweiten Schenkel 8 des zweiten Kerns 4 ein erster Luftspalt 11 und zwischen dem zweiten Schenkel 7 des ersten Kerns 3 und dem ersten Schenkel 6 des zweiten Kerns 4 ein zweiter Luftspalt 12 angeordnet. Vorzugsweise weist das induktive Bauteil 1 genau zwei Luftspalte 11, 12 auf. Die Luftspalte 11, 12 gewährleisten die Sättigungsfestigkeit des induktiven Bauelements 1, d.h., sie verhindern, dass das Bauteil 1 in Sättigung geht.

Das induktive Bauteil 1 weist die Form eines Rechteckkerns auf. Das induktive Bauteil 1 kann auch abgerundete Ecken aufweisen. Das induktive Bauteil 1 weist eine Öffnung 19 zur Durchführung der Stromschiene 2 auf. Die Öffnung 19 weist eine Höhe h und eine Breite b auf (siehe Figur 1B). Die Höhe h setzt sich dabei aus der Länge eines ersten Schenkels 5, 6, der Länge eines zweiten Schenkels 7, 8 und der Höhe eines Luftspaltes 11, 12 zusammen.

Das induktive Bauteil 1 umschließt die Stromschiene 2. Die Stromschiene 2 weist eine rechteckige Querschnittsgeometrie auf. Insbesondere weist die Stromschiene 2 jeweils zwei einander gegenüberliegende Längsseiten 13, 14 und zwei gegenüberliegende Stirnseiten 15, 16 auf. Die Höhe der Längsseiten 13, 14 ist etwas geringer als die Höhe h der Öffnung. Die Breite der Stirnseiten 15, 16 ist etwas geringer als die Breite b der Öffnung.

Beispielsweise weist die Stromschiene eine Abmessung von 50 mm x 10 mm, das induktive Bauteil eine Abmessung von 85 mm x 46 mm, die Öffnung eine Abmessung von 55 mm x 16 mm und der Spalt eine Abmessung von 5 mm auf. Der Strom beträgt in der Anwendung beispielsweise 1600 A. Die Verringerung der Verluste im induktiven Bauteil betragen beispielsweise 28%, was einer Verringerung der Verluste im Gesamtfilter von ca. 10% entspricht.

Vorzugsweise ist das induktive Bauteil 1 punktsymmetrisch ausgebildet. Insbesondere ist das induktive Bauteil 1 symmetrisch bezüglich einer Drehung um 180° um eine Achse ausgebildet, die entlang der Stromrichtung und zentral durch die Öffnung verläuft. Die Kerne 3, 4 weisen beispielsweise eine identische Geometrie auf.

Die Luftspalte 11, 12 befinden sich an gegenüberliegenden Seiten 21, 22 des Bauteils 1. Entsprechend befinden sich die Luftspalte 11, 12 an gegenüberliegenden Längsseiten 13, 14 der Stromschiene 2. Die Luftspalte 11, 12 befinden sich insbesondere nur an den Längsseiten 13, 14 der Stromschiene 2 und nicht an den Stirnseiten der Stromschiene 2. Entsprechend weist das induktive Bauteil 1 Längsseiten und Stirnseiten auf, wobei sich die Luftspalte 11, 12 nur an den Längsseiten des Bauteils 1 befinden. Die Stirnseiten weisen keine Luftspalte auf.

Die Luftspalte 11, 12 sind in ihrer Höhe gegeneinander versetzt angeordnet. Die Höhenrichtung 17 ist eine Richtung senkrecht zum Verlauf der Stromschiene 2. Die Höhenrichtung 17 verläuft parallel zu den Seiten 21, 22 des Bauteils 1, an dem die Luftspalte 11, 12 angeordnet sind. Die
Breitenrichtung 18 verläuft senkrecht zur Stromrichtung in der Stromschiene 2 und senkrecht zur Höhenrichtung 17.

Insbesondere sind die Luftspalte 11, 12 unsymmetrisch bezüglich Spiegelung an einer Mittelebene durch die Stromschiene 2 angeordnet. Die Mittelebene ist eine Ebene, die zwischen den Längsseiten 13, 14 und parallel zu den Längsseiten 13, 14 verläuft. Insbesondere befinden sich die Luftspalte 11, 12 nicht auf gleicher Höhe an den Längsseiten 13, 14.

Beispielsweise liegt der erste Luftspalt 11 in einem Bereich unterhalb der halben Höhe der Längsseite 13. Der zweite Luftspalt 12 liegt beispielsweise in einem Bereich oberhalb der halben Höhe der Längsseite 14. Somit sind beide Luftspalte 11, 12 nicht mittig bezüglich der jeweiligen Längsseite 13, 14 angeordnet.

Die Öffnung 19 weist beispielsweise eine Höhe h von 55 mm auf. Die Luftspalte 11, 12 weisen beispielsweise in Höhenrichtung 17 einen Abstand d von 25 mm auf. Dieser Abstand d wird im Folgenden auch als Spaltverschiebung bezeichnet. Die Luftspalte 11, 12 weisen beispielsweise eine Höhe von 5 mm auf. Somit sind die ersten Schenkel 5, 6 von den zweiten Schenkeln 7, 8 jeweils 5 mm beabstandet. Die Kerne 3, 4 sind beispielsweise jeweils als U-Kerne oder C-Kerne mit unterschiedlichen langen Schenkeln 5, 6, 7, 8 ausgebildet.

Durch eine Spaltverschiebung der Luftspalte 11, 12 kann eine homogenere Stromverteilung in den Stromschienen 2 erreicht werden als bei Luftspalten, die keine Spaltverschiebung aufweisen. Bei Bauteilen ohne Spaltverschiebung befinden sich die Luftspalte 11, 12 beidseitig mittig neben der Stromschiene, insbesondere auf halber Höhe der Längsseiten. Eine inhomogene Stromverteilung beruht auf frequenzabhängigen Stromverdrängungseffekten. Diese Stromverdrängungseffekte können bereits bei niedrigen Frequenzen, z. B. bei 50 Hz, eine nicht zu vernachlässigende Rolle spielen und führen zu unerwünschten Verlusten in der Stromschiene 2. Insbesondere tritt bei symmetrisch angeordneten Luftspalten eine hohe Stromdichte im Bereich der Luftspalte auf, die nach oben und unten abnimmt.

Derartige Verluste werden üblicherweise durch eine Vergrößerung des Querschnitts der Stromschiene 2 oder eine verbesserte Wärmeabfuhr verringert. Allerdings führen beide Ansätze zu einer Vergrößerung des Volumens und/oder einer Erhöhung der Kosten der Anordnung 20. Durch die Verschiebung der Luftspalte 11, 12 gegeneinander können die Verluste ohne Volumenvergrößerung oder Kostenerhöhung verringert werden. Insbesondere ist bei einer Verschiebung der Luftspalte die Stromdichte in der Stromschiene deutlich homogener als bei Luftspalten, die auf gleicher Höhe angeordnet sind.

Es hat sich beispielsweise gezeigt, dass bei einer Öffnung mit 50 mm Höhe und einer ähnlich hohen Stromschiene 2 bereits eine Spaltverschiebung von 5 mm zu einer Reduzierung der Verluste um ca. 1% führt. Bei einer Spaltverschiebung von 25 mm konnten die Verluste um 10 % reduziert werden. Bei einer weiteren Verschiebung der Luftspalte hin zum Rand der Kerne 3, 4, d.h. in Richtung der Verbindungsstücke 9, 10 nehmen die Verluste wieder zu, da sich die induktive Wirkung am Rand erhöht. Ein optimaler Bereich für den Abstand der Luftspalte liegt insbesondere in einem Bereich um die halbe Höhe der Öffnung bzw. der Stromschiene, beispielsweise in einem Bereich von 0,25·h bis 0,7·h. Bei derartigen Spaltverschiebungen konnten die Verluste in dem induktiven Bauteil um mehr als 20% reduziert werden.

### Bezugszeichenliste

- 1: induktives Bauteil
- 2: Stromschiene
- 3: erster Kern
- 4: zweiter Kern
- 5: erster Schenkel des ersten Kerns
- 6: erster Schenkel des zweiten Kerns
- 7: zweiter Schenkel des ersten Kerns
- 8: zweiter Schenkel des zweiten Kerns
- 9: Verbindungsstück des ersten Kerns
- 10: Verbindungsstück des zweiten Kerns
- 11: erster Luftspalt
- 12: zweiter Luftspalt
- 13: Längsseite der Stromschiene
- 14: Längsseite der Stromschiene
- 15: Stirnseite
- 16: Stirnseite
- 17: Höhenrichtung
- 18: Breitenrichtung
- 19: Öffnung
- 20: Anordnung
- 21: Seite des Bauteils
- 22: Seite des Bauteils
- 23: weiterer Kern
- 24: weiterer Kern

- h: Höhe der Öffnung
- b: Breite der Öffnung
- d: Abstand der Luftspalte

## Patentansprüche

1. Anordnung aufweisend ein induktives Bauteil (1) und eine Stromschiene (2),
wobei die Stromschiene (2) durch das induktive Bauteil (1) geführt ist,
wobei die Stromschiene (2) zwei gegenüberliegende Längsseiten (13, 14) und zwei gegenüberliegende Stirnseiten (15, 16) aufweist, wobei sich die Längsseiten (13, 14) in eine Höhenrichtung (17) erstrecken und sich die Stirnseiten (15, 16) in eine Breitenrichtung (18) erstrecken, wobei die Breitenrichtung (18) senkrecht zur Höhenrichtung (17) verläuft, wobei die Erstreckung der Längsseiten (13, 14) größer ist als die Erstreckung der Stirnseiten (15, 16), wobei das induktive Bauteil (1) zwei Luftspalte (11, 12) aufweist, die an den gegenüberliegenden Längsseiten (13, 14) der Stromschiene (2) angeordnet sind, wobei die Luftspalte (11, 12) in der Höhenrichtung (17) einen Abstand (d) voneinander aufweisen, wobei das induktive Bauteil (1) einen ersten Kern (3) und einen zweiten Kern (4) aufweist, wobei jeder Kern (3, 4) einen ersten Schenkel (5, 6) und einen zweiten Schenkel (7, 8) aufweist, wobei der erste Schenkel (5, 6) eine andere Länge aufweist als der zweite Schenkel (7, 8),
bei dem sich die Luftspalte (11, 12) zwischen den Kernen (3, 4) befinden,
bei dem ein erster Luftspalt (11) der genannten Luftspalte zwischen dem ersten Schenkel (5) des ersten Kerns (3) und dem zweiten Schenkel (8) des zweiten Kerns (4) und ein zweiter Luftspalt (12) der genannten Luftspalte zwischen dem zweiten Schenkel (7) des ersten Kerns (3) und dem ersten Schenkel (6) des zweiten Kerns (4) angeordnet ist.

2. Anordnung nach Anspruch 1,
bei dem der Abstand (d) der Luftspalte (11, 12) in Höhenrichtung (17) mindestens 1/4 der Summe der Längen eines ersten Schenkels (5, 6), eines zweiten Schenkels (7, 8) und einer Erstreckung eines Luftspalts (11, 12) in Höhenrichtung beträgt.

3. Anordnung nach einem der vorhergehenden Ansprüche,
bei dem der Abstand (d) der Luftspalte (11, 12) in Höhenrichtung (17) höchstens 3/4 der Summe der Längen eines ersten Schenkels (5, 6), eines zweiten Schenkels (7, 8) und einer Erstreckung eines Luftspalts (11, 12) in Höhenrichtung beträgt.

4. Anordnung nach einem der vorhergehenden, bei dem die Kerne (3, 4) die gleiche Form aufweisen.

5. Anordnung nach einem der vorhergehenden Ansprüche,
bei dem wenigstens einer der Kerne (3, 4) die Form eines "U"-Kerns oder eines "C"-Kerns mit unterschiedlich langen Schenkeln (5, 6, 7, 8) aufweist.

6. Anordnung nach Anspruch 5,
bei dem beide Kerne (3,4) die Form eines "U"-Kerns oder eines "C"-Kerns" mit unterschiedlich langen Schenkeln (5, 6, 7, 8) aufweisen, wobei jeder der Luftspalte (11, 12) an beide Kerne (3, 4) angrenzt.

7. Anordnung nach einem der vorhergehenden Ansprüche,
wobei das induktive Bauteil (1) punktsymmetrisch ausgebildet ist.

8. Anordnung nach einem der vorhergehenden Ansprüche,
wobei sich Luftspalte (11, 12) nur an den Längsseiten befinden.

9. Anordnung nach einem der vorhergehenden Ansprüche,
bei der das induktive Bauteil (1) für einen EMV-Filter ausgebildet ist.

10. Anordnung nach einem der vorhergehenden Ansprüche, bei dem jeder der Kerne (3, 4) einstückig ausgebildet ist.

11. Anordnung nach einem der Ansprüche 1 bis 10,
bei dem jeder der Kerne (3, 4) aus einzelnen Kernen zusammengesetzt ist.

## Claims

1. Arrangement comprising an inductive component (1) and a busbar (2),
wherein the busbar (2) is led through the inductive component (1),
wherein the busbar (2) has two opposite longitudinal sides (13, 14) and two opposite face sides (15, 16), wherein the longitudinal sides (13, 14) extend in a height direction (17) and the face sides (15, 16) extend in a width direction (18), wherein the width direction (18) runs perpendicular to the height direction (17), wherein the extent of the longitudinal sides (13, 14) is greater than the extent of the face sides (15, 16), wherein the inductive component (1) has two air gaps (11, 12) which are arranged on the opposite longitudinal sides (13, 14) of the busbar (2), wherein the air gaps (11, 12) are at a distance (d) from one another in the height direction (17), wherein the inductive component (1) comprises a first core (3) and a second core (4), wherein each core (3, 4) has a first limb (5, 6) and a second limb (7, 8), wherein the first limb (5, 6) has a different length than the second limb (7, 8),
in which the air gaps (11, 12) are located between the cores (3, 4),
in which a first air gap (11) of the mentioned air gaps is arranged between the first limb (5) of the first core (3) and the second limb (8) of the second core (4), and a second air gap (12) of the mentioned air gaps is arranged between the second limb (7) of the first core (3) and the first limb (6) of the second core (4).

2. Arrangement according to Claim 1,
in which the distance (d) between the air gaps (11, 12) in the height direction (17) is at least 1/4 of the sum of the lengths of a first limb (5, 6), of a second limb (7, 8) and of an extent of an air gap (11, 12) in the height direction.

3. Arrangement according to either of the preceding claims,
in which the distance (d) between the air gaps (11, 12) in the height direction (17) is at most 3/4 of the sum of the lengths of a first limb (5, 6), of a second limb (7, 8) and of an extent of an air gap (11, 12) in the height direction.

4. Arrangement according to one of the preceding claims,
in which the cores (3, 4) have the same shape.

5. Arrangement according to one of the preceding claims,
in which at least one of the cores (3, 4) has the shape of a "U" core or of a "C" core with limbs (5, 6, 7, 8) of different lengths.

6. Arrangement according to Claim 5,
in which both cores (3, 4) have the shape of a "U" core or of a "C" core with limbs (5, 6, 7, 8) of different lengths, wherein each of the air gaps (11, 12) adjoins both cores (3, 4).

7. Arrangement according to one of the preceding claims,
wherein the inductive component (1) is of point-symmetrical design.

8. Arrangement according to one of the preceding claims,
wherein air gaps (11, 12) are located only at the longitudinal sides.

9. Arrangement according to one of the preceding claims,
in which the inductive component (1) is designed for an EMC filter.

10. Arrangement according to one of the preceding claims,
in which each of the cores (3, 4) is formed in one piece.

11. Arrangement according to one of Claims 1 to 10,
in which each of the cores (3, 4) is composed of individual cores.

## Revendications

1. Agencement présentant un composant inductif (1) et une barre omnibus (2),
dans lequel la barre omnibus (2) est guidée à travers le composant inductif (1),
dans lequel la barre omnibus (2) présente deux faces longitudinales opposées (13, 14) et deux faces frontales opposées (15, 16), dans lequel les faces longitudinales (13, 14) s'étendent dans un sens de la hauteur (17) et les faces frontales (15, 16) s'étendent dans un sens de la largeur (18), dans lequel le sens de la largeur (18) s'étend perpendiculairement au sens de la hauteur (17), dans lequel l'extension des faces longitudinales (13, 14) est supérieure à l'extension des faces frontales (15, 16), dans lequel le composant inductif (1) présente deux entrefers (11, 12) qui sont disposés sur les faces longitudinales opposées (13, 14) de la barre omnibus (2), dans lequel les entrefers (11, 12) présentent dans le sens de la hauteur (17) un écart (d) entre eux, dans lequel le composant inductif (1) présente un premier noyau (3) et un deuxième noyau (4), dans lequel chaque noyau (3, 4) présente une première branche (5, 6) et une deuxième branche (7, 8), dans lequel la première branche (5, 6) présente une longueur différente de la deuxième branche (7, 8),
dans lequel les entrefers (11, 12) se trouvent entre les noyaux (3, 4),
dans lequel un premier entrefer (11) desdits entrefers est disposé entre la première branche (5) du premier noyau (3) et la deuxième branche (8) du deuxième noyau (4), et un deuxième entrefer (12) desdits entrefers est disposé entre la deuxième branche (7) du premier noyau (3) et la première branche (6) du deuxième noyau (4).

2. Agencement selon la revendication 1, dans lequel l'écart (d) des entrefers (11, 12) dans le sens de la hauteur (17) est au minimum 1/4 de la somme des longueurs d'une première branche (5, 6), d'une deuxième branche (7, 8) et d'une extension d'un entrefer (11, 12) dans le sens de la hauteur.

3. Agencement selon l'une quelconque des revendications précédentes, dans lequel l'écart (d) des entrefers (11, 12) dans le sens de la hauteur (17) correspond au maximum à 3/4 de la somme des longueurs d'une première branche (5, 6), d'une deuxième branche (7, 8) et d'une extension d'un entrefer (11, 12) dans le sens de la hauteur.

4. Agencement selon l'une quelconque des revendications précédentes, dans lequel les noyaux (3, 4) présentent la même forme.

5. Agencement selon l'une quelconque des revendications précédentes, dans lequel au moins l'un des noyaux (3, 4) présente la forme d'un noyau en U ou d'un noyau en C avec des branches (5, 6, 7, 8) de longueur différente.

6. Agencement selon la revendication 5, dans lequel les deux noyaux (3, 4) présentent la forme d'un noyau en U ou d'un noyau en C avec des branches (5, 6, 7, 8) de longueur différente, dans lequel chacun des entrefers (11, 12) est adjacent aux deux noyaux (3, 4).

7. Agencement selon l'une quelconque des revendications précédentes, dans lequel le composant inductif (1) est réalisé en symétrie ponctuelle.

8. Agencement selon l'une quelconque des revendications précédentes, dans lequel des entrefers (11, 12) ne sont présents que sur les faces longitudinales.

9. Agencement selon l'une quelconque des revendications précédentes, dans lequel le composant inductif (1) est réalisé pour un filtre CEM.

10. Agencement selon l'une quelconque des revendications précédentes, dans lequel chacun des noyaux (3, 4) est réalisé d'un seul tenant.

11. Agencement selon l'une quelconque des revendications 1 à 10, dans lequel chacun des noyaux (3, 4) est composé de noyaux individuels.
